# EUROPEAN PATENT APPLICATION

(11) **EP 0 893 881 A2**
(43) Date of publication of application: **27.01.1999**
(21) Application number: 98305444.6
(22) Date of filing: 08.07.1998
(51) Int. Cl.: H03H 7/46

(54) **Diplexer for full duplex communications**

(30) Priority: 22.07.1997 GB 9715486
(71) Applicant: Caradon Friedland Limited, Weybridge, Surrey KT13 9UX (GB)
(72) Inventor: Bolton, David Robert, Wythenshawe, Manchester M23 9BR (GB)
(74) Representative: Sarup, David Alexander

(57) **Abstract**

The diplexer consists of two reactive power splitters (splitter 1, splitter 2) and a reactive network (LC).

The first power splitter has a first port (a) connected in use to a generator (Tx) of a signal for transmission at a predetermined transmission frequency, a second port (S1) connected, in use, to an antenna operative to transmit and receive, and a third port (b) connected to the second power splitter. The second power splitter having a first port (c) connected to the third port (b) of the first power splitter, a second port (S2) connected to the reactive network (LC) and a third port (d) connected in use to processing circuitry for received signals. The reactive network is adapted to act as a notch filter centred on the transmission frequency to attenuate signal components having at least substantially the transmission frequency.

## Description

This invention relates to a diplexer for full duplex communications.

The use of diplexer circuits to allow the use of separate frequencies for simultaneous transmission and reception (full duplex operation) on a single antenna or cable is well established. Classical diplexer designs employ combinations of low, high and bandpass structures.

The spacing of the frequencies which can be employed (all other communication parameters being equal) is determined by the nature of the filters employed to construct the diplexer. The closer the frequencies employed, in general, the bigger and more expensive the filters required become if losses, which degrade the quality of the communication, are to be minimised.

At high frequencies, for example those employed by the analogue cellular telephones, compact bandpass structures can be fabricated using dielectric components. These offer a low loss and they are suitable for the wide frequency separation between the transmitted and received frequencies.

In the domain of licence exempt communications, devices must function in relatively narrow frequency bands, which whilst advantageous for single antenna work, imposes stringent requirements upon any diplexer circuit which may be employed to allow full duplex operation. Such requirements have hitherto implied that true full duplex operation is difficult to achieve.

According to one aspect of the present invention, there is provided a diplexer comprising two reactive power splitters and a reactive network.

According to a second aspect of the present invention, there is provided a door entry system incorporating a diplexer comprising two reactive power splitters and a reactive network.

The reactive network can be a series LC network.

For a better understanding of the present invention and to show how the same may be carried into effect, reference will now be made, by way of example, to the accompanying drawings, in which:-
Figure 1 is a block diagram of a known form of communication link provider,
Figure 2 is a circuit diagram of a known transformer based power splitter,
Figure 3 is a graph to illustrate the functioning of the known circuit of Figure 2,
Figure 4 is a view of another known splitter arrangement,
Figure 5 is a graph illustrating impedance of an inductor,
Figure 6 is a graph of attenuation v. frequency with the present arrangement,
Figure 7 is a block diagram of a diplexer arrangement according to the invention,
Figure 8 is a graph similar to Figure 6, showing results of varying impedances, and
Figure 9 is another graph, similar to Figure 8, but showing characteristics of a quartz crystal incorporated in the circuit instead of the series arrangement of Figure 7.

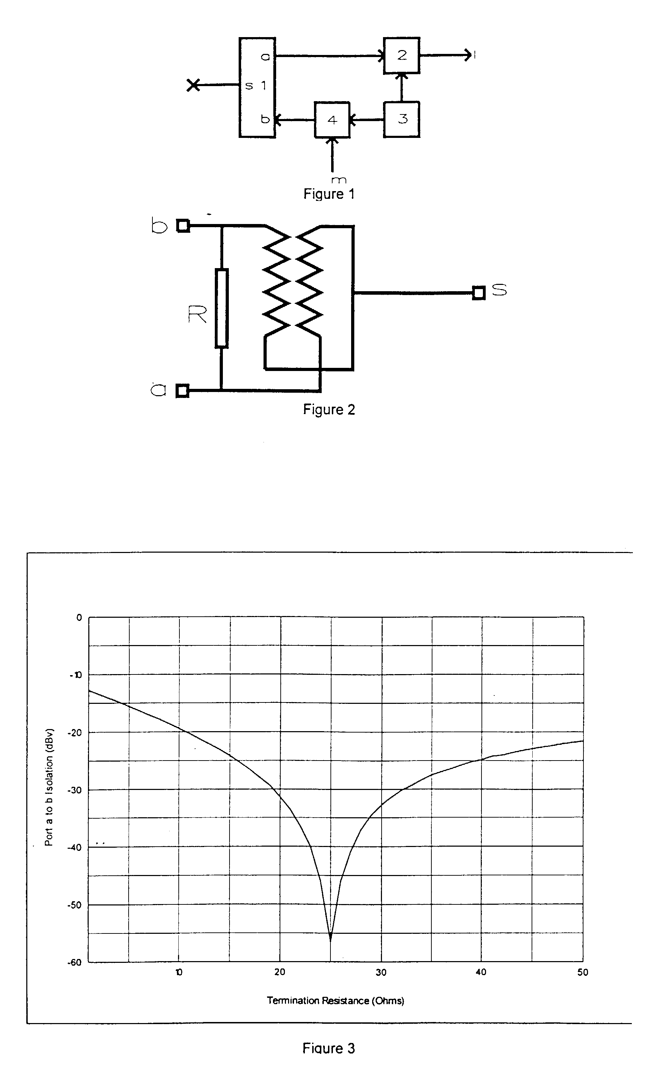

A known solution often employed by lower quality communication link providers is shown in Figure 1.

Block 1 is a power splitter combiner. Power applied to a port s is divided between ports a and b. Power delivered to port a is delivered to port s, and power delivered to port b is delivered to port s; in the ideal case none of the power delivered to port a is delivered to port b, and vice versa

Block 2 is a receiver mixer. The signal which is to be received is applied to port s of the splitter of Block 1 and the fraction of this applied signal delivered to port a is converted by a heterodyne process involving the oscillator frequency produced by an oscillator Block 3 to a frequency suitable for further processing.

Block 3 is the oscillator, which is a circuit which produces the so-called local oscillator signal for the receiver, and which in this application is used as the transmit frequency.

Block 4 represents modulator and transmitter stages. The information applied to port m is used to modulate a signal delivered to the this stage from the oscillator. The output of this stage delivered to port b of the splitter and thence to port s.

Taking a numerical example, based on the 27 MHz licence exempt frequency band, an incoming signal at 27.2 MHz is applied to port s. The fraction of the power delivered from port s to port b is lost, and in this context is unimportant. The fraction of the power applied to port s and delivered to port a is now applied to the mixer circuit and is mixed with a frequency of 27.4 MHz produced by the oscillator. The signal at the mixer output is filtered and further processed to reproduce any information contained by the incoming signal.

The 27.4 MHz signal produced by the oscillator block is modulated and amplified, and the resultant signal applied to port b of the splitter and thence to port s from which it is launched into the transmitting medium.

To complete the system a second circuit, consisting of the same circuits, is required. In this second system, the incoming signal is at 27.4 MHz and the oscillator produces 27.2 MHz. Thus, providing the mixer is not overloaded by any signal leaking from port b to port a, these two units form a simple duplex system.

The performance of the system is limited by the performance of the splitter combiner block. In theory, any signal leaking from port b to port a mixes with itself in the mixer and produces a DC signal, which is of no importance to the system. In practice however the leaking signal desensitises the mixer by either saturating its input, saturating its output, or the DC signal produced upsets the mixer bias. In any of these cases the result is the same, the system performance degrades.

In its simplest form, the splitter can be a soldered joint if care is taken to maintain the impedance levels; this however introduces no isolation between ports a and b. A more sophisticated splitter employs a resistor network, but the isolation obtained between ports a and b is also reflected as a loss introduced between the sum port s and ports a and b; this can only reduce the system performance. Such systems cannot therefore be regarded as true diplexer circuits.

Clearly, the system performance can be restored to its optimum if the isolation between ports a and b can be increased, without introducing additional loss between port a and port s. Suitable frequency selective components can be introduced which will reject the unwanted signals at each port, but which must be large if losses are to be minimised.

The use of transformer based power splitters can solve the above problems. Such devices are commercially available from Mini-Circuits. The equivalent circuit of the transformer based power splitter is shown in Figure 2.

As previously, power delivered to port s is split between ports a and b, whilst signals applied to ports a and b are combined at port s. This time however, by correctly terminating port s, the isolation obtained between ports and b is infinite. The correct termination impedance for a port s is determined by the design of the transformer network. It is important to realise that the transformer is a transmission line system and as such has a characteristic impedance Zₒ.

Minimum insertion loss from port s to ports a and b will occur when port s is terminated in a value of zo/2; R has a value of 2zo and ports a and b are terminated in zo. Under these conditions, power applied to port s will be equally divided between ports a and b (i.e. 1/2 the power to each). However power applied to port a(b) will not be delivered to port b(a). Interestingly, if ports a and b are not terminated in zo, whilst the insertion loss from port s to port a or b will be detrimentally affected, the isolation between ports a and b is hardly affected.

Figure 3 shows how the isolation between ports a and b varies with the termination resistance at port s.

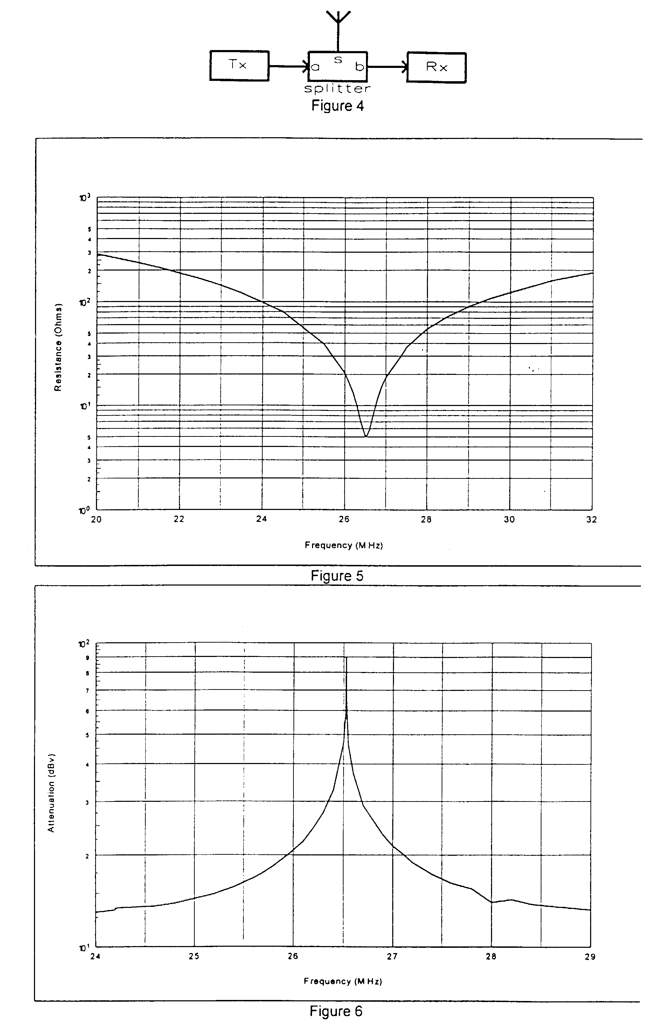

An antenna offering a 25Ω resistance at the correct frequency when used as the termination for port s would clearly offer very large attenuations between ports a and b whilst delivering power from a to s and s to a with minimum losses. Figure 4 shows a splitter used as a diplexer with port s terminated in an antenna. In the numerical example used above a relatively broad band impedance extending from 27.2 MHz to 27.4 MHz would be required.

Clearly then, if the splitter is used as shown in Figure 4, a perfect diplexer is formed if port s is correctly terminated. In a wireless application port s can be terminated in an antenna designed to have a purely resistive component of z0/2 at the transmission frequency, providing a large isolation between ports a and b at the transmission frequency, whilst delivering transmitter power to the sum port s from port a, and received power from the sum port s to port a. However, the isolation obtained between ports a and b by relying on the impedance of the antenna is not reliable, because the impedance presented by the antenna to the sum port s is highly dependant upon the environment into which the antenna is placed. For an antenna in free space the impedance is known and unlikely to vary; however, in a hand held environment the antenna environment can change as the hand held unit is moved relatively to the body of the user and the impedance can change, whereby output can drop dramatically.

A method of ensuring that the isolation obtained does not fall below an acceptable minimum can be realised by employing the properties of the splitter and series LC circuits (a tuned or resonant circuit). At resonance, the impedance of a series tuned LC network falls to the dynamic resistance of an inductor, the effect of a finite capacitance Q is negligible due to the very high Q of the capacitor. Figure 5 shows the impedance of a 3µH inductor having a Q of 100 and a 12pF capacitor. The impedance falls close to 5Ω as expected from the Q value. Note that the impedance is only purely resistive at the frequency producing this minimum resistance (the resonant frequency). Placing an additional 20Ω in series with this network will give a pure resistance of 25Ω when the circuit comes to resonance.

Connected to the sum port s of a reactive splitter, the isolation between ports a and b will become frequency selective. Figure 6 shows the isolations obtained with purely resistive and reactive sum port s terminations as functions of frequency.

An attenuation notch is produced by the use of the series resonant LC circuit. The invention envisages the use of two splitters and a reactive network to produce a diplexing circuit with deep notch characteristics which acts as a stable filter of unwanted noise. The diplexer can be used in a door entry system such as a door 'phone system. As described above, available systems tend to rely on a simple summing junction, and by using the transmit frequency as the local oscillator produces a DC level at the mixer output, which is considered insignificant.

However, blocking still occurs and the receiver is desensitised, reducing the range over which the door entry system functions. The use of a true diplexer according to the invention removes the transmit frequency from the receiver input, preventing desensitisation and thus increasing the range.

The diplexer according to the invention uses two reactive power splitters and a series LC network.

As described above, the antenna can in theory provide the correct impedance to the sum port of a reactive splitter to provide the required isolation in a system as shown in Figure 4. However changing environments mean that the antenna impedance cannot be relied upon and the isolation of the splitter cannot be guaranteed to be adequate.

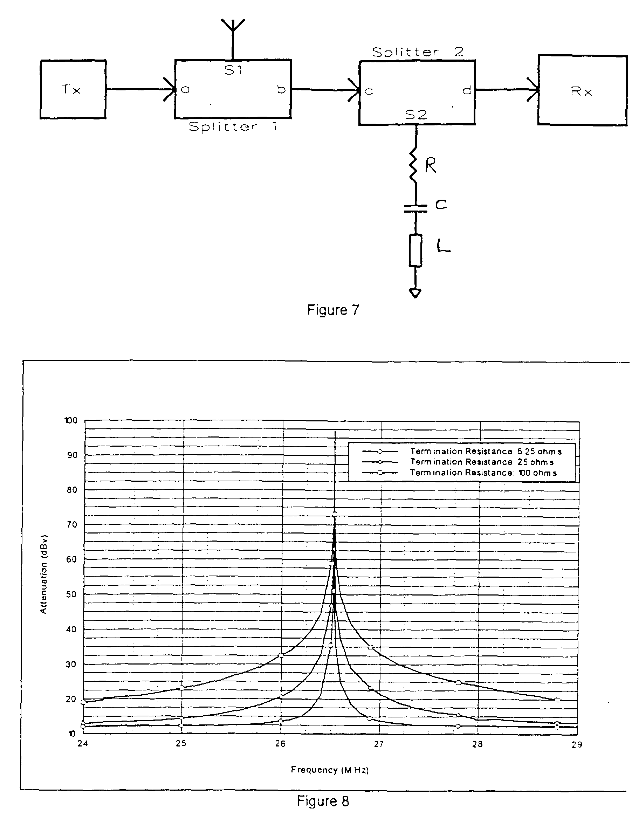

Figure 7 shows how two splitters and a reactive network can be used to produce a diplexer which is independent of the antenna environment.

Splitter 1 performs the basic splitting/combining function. The power from the transmitter at port a is coupled to the antenna at port S1; clearly if the antenna impedance is correct, considerable attenuation of the transmitter power occurs between ports a and b. Received power is coupled from the antenna at S1 to port b. The required attenuation of the transmitter power coupled to port c on splitter 2, due to the non optimal termination of the port S1 by the antenna, is performed by the notch produced by the reactive network on port S2. By placing the peak attenuation over the transmitted frequency, the transmitter power is attenuated between ports c and d. However, at the receive frequency the termination of port S2 is not ideal and little attenuation of the received signal occurs. The reactive network on S2 is constructed in such a manner that it is unaffected by its local environment. Thus, if when ideally terminated at the sum port an isolation of ndB is produced, this will always be the minimum attenuation produced by this new two splitter diplex circuit. Additional attenuation will be obtained as the match on S1 improves; the theoretical maximum attenuation is 2n dB. The notch shown in Figure 6 is produced by a network represented on port S2 as a series LC circuit. The series LC network can however be realised in a number of ways, in particular a crystal could be employed to produce a highly stable very narrow notch. Other reactive networks connected to port S2 produce other transmission characteristics between ports c and d.

With the present arrangement, optimum termination impedance of the summing port controls the notch width. The narrower the notch, the closer the transmitter and receiver frequencies can be. The notch shown in Figure 6 is obtained when the ideal termination impedance is zo/2. By using suitable matching networks, the intrinsic zo/2 impedance at the sum port can be transformed to required value. The effect of transforming the sum port impedance to both higher and lower impedance's than zo/2 is shown in Figure 8.

This reduction in the notch width is governed by the Q of the network connected to the sum port; which in turn relates to the series resistance of the series LC network shown in the example at Figure 7.

The required impedance transformation can be achieved in a number of ways. The classic Ruthroff and Guanella transmission line transformers provide simple means of achieving impedance transformations of 3:1, 4:1, multiples thereof and some non integer impedance transformations; whilst the so called ROTRA transmission line configuration provides non integer transformation matching networks. These transformers are wideband structures and maintain the intrinsically wide bandwidth of the transformer based diplexer.

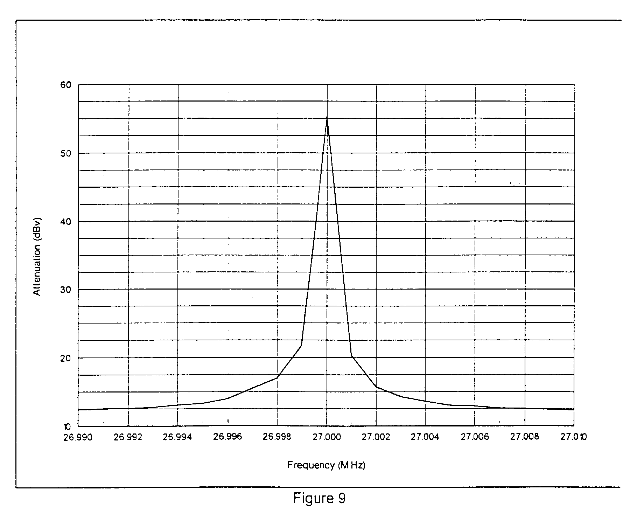

A quartz crystal, which can be represented as having an equivalent circuit consisting of a series LCR network, will provide a much narrower notch. Figure 9 shows the notch produced for a 27MHz crystal having a Q of 9500. Parallel resonant networks can also be employed.

## Claims

1. A diplexer comprising two reactive power splitters and a reactive network.

2. A diplexer according to claim 1, in which the first power splitter (1) has a first port (a) connected in use to a generator (Tx) of a signal for transmission at a predetermined transmission frequency, a second port (S1) connected, in use, to an antenna operative to transmit and receive, and a third port (b) connected to the second power splitter (2), the second power splitter having a first port (c) connected to the third port (b) of the first power splitter, a second port (S2) connected to the reactive network (LCR) and a third port (d) connected in use to processing circuitry for received signals, in which the reactive network (LCR) is adapted to act as a notch filter centred on the transmission frequency to attenuate signal components having at least substantially the transmission frequency.

3. A diplexer according to claim 1 or claim 2, wherein the reactive network is, and/or has an equivalent circuit of, a series LC network or series LCR network.

4. A diplexer according to claim 3, wherein the reactive circuit comprises a crystal.

5. A diplexer according to claim 4, wherein the crystal is quartz.

6. A door entry system incorporating a diplexer according to any preceding claim.

7. A door entry system according to claim 6, including the signal generator (Tx), antenna and processing circuitry.

8. A door entry system according to claim 6 or claim 7, which is a door entry phone system.
